# FASCICULE DE BREVET EUROPEEN

(11) **EP 3 968 388 B1**
(45) Date de publication et mention de la délivrance du brevet: **29.03.2023**
(21) Numéro de dépôt: 21195460.7
(22) Date de dépôt: 08.09.2021
(51) Int. Cl.: H01L 29/66, H01L 29/78

(54) **PROCÉDÉ DE FABRICATION D'UNE ZONE DOPÉE D'UN DISPOSITIF MICROÉLECTRONIQUE**
VERFAHREN ZUR HERSTELLUNG EINES MIT EINER MIKROELEKTRONISCHEN VORRICHTUNG DOTIERTEN BEREICHS
METHOD FOR MANUFACTURING A DOPED AREA OF A MICROELECTRONIC DEVICE

(30) Priorité: 10.09.2020 FR 2009167
(43) Date de publication de la demande: 16.03.2022
(73) Titulaire: Commissariat à l'Energie Atomique et aux Energies Alternatives, 75015 Paris (FR)
(72) Inventeur: REBOH, Shay, 38054 GRENOBLE Cedex 09 (FR); COLINGE, Jean-Pierre, Carmichael, CA 95608 (US)
(74) Mandataire: Hautier IP

(56) Documents cités:
- US-A1- 2013 020 640
- US-A1- 2015 162 436
- US-A1- 2015 311 207
- US-A1- 2017 053 912
- US-B1- 10 134 901

## Description

### DOMAINE TECHNIQUE

La présente invention concerne le domaine de la microélectronique. Elle trouve pour application particulièrement avantageuse la réalisation de sources et drains dans des transistors requérant de faibles budgets thermiques, notamment dans le domaine de l'intégration 3D monolithique.

### ETAT DE LA TECHNIQUE

Dans l'industrie des semi-conducteurs, une diversification des architectures de transistors est apparue afin de respecter les noeuds technologiques définis par la feuille de route internationale pour le développement technologique des semi-conducteurs (ITRS).

Les architectures de transistors FinFET ont montré un grand potentiel pour continuer à augmenter les performances des transistors selon l'ITRS. D'autres architectures, comme les transistors à grille enrobante GAA ou les transistors à base de nanofils NWFET, ont également montré des niveaux de performances prometteurs.

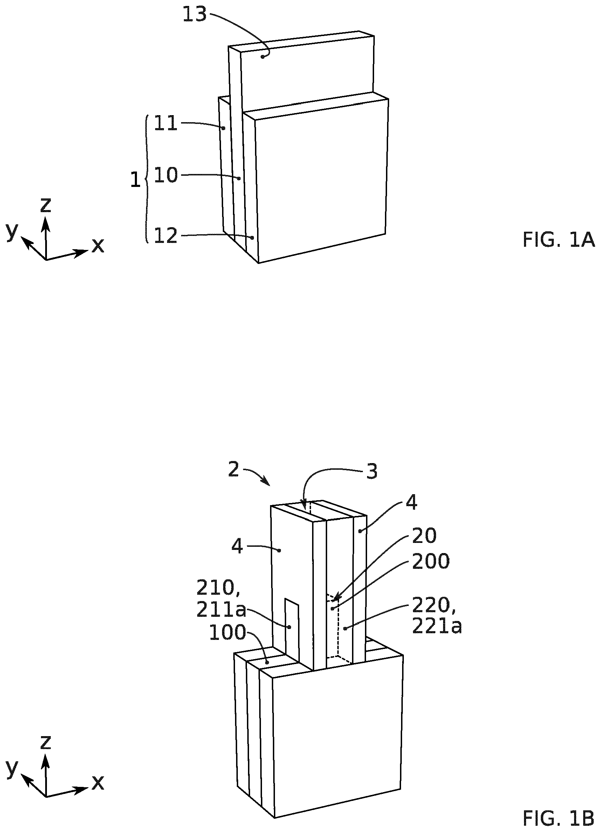

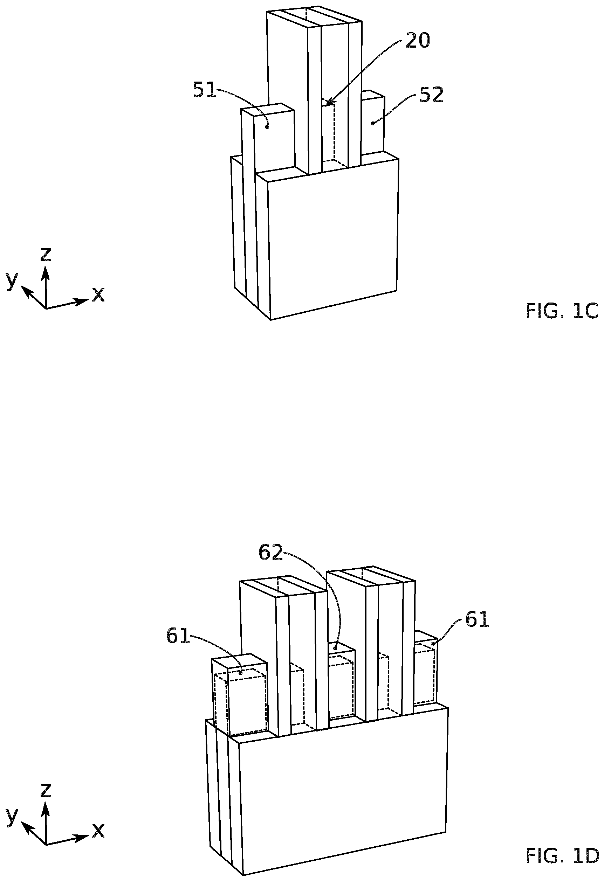

Les figures 1A-1D illustrent une partie des étapes d'un procédé de fabrication d'un transistor FinFET, selon l'art antérieur. Comme illustré à la figure 1A, un aileron 13 est formé sur un substrat 1. Cet aileron 13 surmonte une portion de base 10 du substrat 1. Cette portion de base 10 est typiquement en un matériau semi-conducteur. le substrat 1 comprend également des portions 11, 12 d'isolation situées de part et d'autre de la portion de base 10. L'aileron 13 et la portion de base 10 s'étendent principalement le long d'un axe longitudinal x. Comme illustré à la figure 1B, l'aileron 13 est structuré de manière à former un canal 20 comprenant une portion centrale 200 et des portions latérales 210, 220. Un motif de grille 3 de transistor est formé autour de la portion centrale 200 du canal 20. Des espaceurs 4 sont également formés de part et d'autre du motif de grille 3 et entourent les portions latérales 210, 220 du canal 20. Une gravure est effectuée de façon à exposer une facette 211a, 221a pour chaque portion latérale 210, 220 du canal 20. Un motif de transistor 2 comprenant le motif de grille 3, les espaceurs 4, et les portions centrale 200 et latérales 210, 220 du canal 20, est ainsi obtenu sur le substrat 1. Les régions source et drain 51, 52 du transistor sont alors formés par épitaxie à partir de la portion de la face supérieure 100 de la portion de base 10 du substrat 1 et sur les facettes 211a, 221a exposées du canal 20, comme illustré à la figure 1C. Des contacts 61, 62 peuvent ensuite être déposés sur les régions source et drain 51, 52 du ou des transistors FinFET (figure 1D).

Pour les architectures FinFET, et de façon similaire pour les architectures GAA ou NWFET, les courants de fuite et la résistance d'accès au niveau du contact constituent néanmoins des problématiques importantes. Les courants de fuite se produisent notamment depuis les régions source et drain vers le substrat. Une solution consiste à former une région barrière, typiquement par contre-dopage, sous les régions source et drain dans la portion de base. Cette solution devient néanmoins difficile à mettre en oeuvre lorsque la distance séparant deux transistors ou deux grilles diminue.

Le document US 10,134,901 B1 divulgue une autre solution mise en oeuvre dans la réalisation d'un transistor FinFET. Selon cette solution, un canal en forme d'aileron (« fin » en anglais) à base d'un premier matériau semiconducteur est formé sur une couche à base d'un deuxième matériau semiconducteur. Après formation du canal et avant épitaxie des régions source et drain, une oxydation est réalisée sur les surfaces exposées des premier et deuxième matériaux semiconducteurs. Cela permet de former une portion d'isolation supplémentaire dans la couche à base d'un deuxième matériau semiconducteur, sous les futures régions source et drain. Une désoxydation sélective des surfaces latérales du canal est ensuite effectuée, préalablement à une épitaxie latérale des régions source et drain.

L'inconvénient de cette solution est qu'elle nécessite de recourir à des matériaux différents pour le substrat et pour le canal, afin d'opérer la désoxydation sélective. Un autre inconvénient de cette solution est qu'elle requiert un nombre d'étapes élevé.

Un objet de la présente invention est de pallier au moins en partie certains des inconvénients mentionnés ci-dessus et de trouver une alternative à la solution décrite par le document US 10,134,901 B1.

En particulier, un objet de la présente invention est de proposer un procédé amélioré de formation d'une région source/drain d'un dispositif microélectronique comprenant une portion d'isolation supplémentaire.

Un autre objet de la présente invention est de proposer un dispositif microélectronique comprenant une région source/drain limitant les courants de fuite et/ou diminuant la résistance d'accès au niveau du contact.

Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du procédé peuvent s'appliquer *mutatis mutandis* au dispositif, et réciproquement.

### RESUME

Pour atteindre cet objectif, un premier aspect de l'invention concerne un procédé de formation d'au moins une région source/drain d'au moins un transistor, comprenant les étapes suivantes :
- Fournir un substrat massif portant un motif de transistor,
   Ledit substrat massif comprenant :
      ∘ Une portion de base en un matériau semi-conducteur présentant une face supérieure s'étendant dans un plan basal et allongée le long d'un axe longitudinal, et
      ∘ Des première et deuxième portions d'isolation situées de part et d'autre de ladite portion de base,
   Ledit motif de transistor comprenant :
      ∘ un canal surmontant la portion de base et s'étendant notamment le long de l'axe longitudinal,
      ∘ un motif de grille de transistor entourant transversalement au moins en partie une portion centrale du canal,
      ∘ un espaceur recouvrant un flanc du motif de grille de transistor et entourant transversalement au moins en partie au moins une portion latérale du canal,
      la portion latérale du canal et l'espaceur présentant respectivement une facette et un flanc s'étendant transversalement à l'axe longitudinal,
- Former une portion d'isolation supplémentaire dans la portion de base, par oxydation du matériau semi-conducteur à partir de la face supérieure de la portion de base,
- Former par épitaxie sélective, principalement selon l'axe longitudinal, la région source/drain notamment à partir de ladite facette du canal et de préférence uniquement à partir de ladite facette du canal,
   Avantageusement, le procédé comprend en outre les étapes suivantes :
   - Avant formation de la portion d'isolation supplémentaire, former une couche de protection sur la facette du canal, ladite couche de protection étant configurée pour empêcher une oxydation de la portion latérale du canal lors de la formation par oxydation de la portion d'isolation supplémentaire,
   - Après formation de la portion d'isolation supplémentaire et avant formation de la région source/drain, retirer la couche de protection.

Ainsi, l'oxydation permettant de former la portion d'isolation supplémentaire ne modifie pas la portion latérale du canal. Cette dernière est protégée par la couche de protection durant la formation de la portion d'isolation supplémentaire. Il n'est donc pas nécessaire de prévoir un matériau semi-conducteur pour le substrat différent du matériau du canal. Cela permet de relâcher les contraintes sur le choix du ou des matériaux semiconducteurs utilisés.

En outre, il n'est pas nécessaire de prévoir en amont un retrait dimensionnel du canal - couramment appelé *recess* - selon l'axe longitudinal, qui se produit lors de la désoxydation sélective enseignée par les solutions connues. Cela simplifie la gestion des étapes du procédé. La facette de la portion latérale du canal est d'abord couverte par la couche de protection, avant formation de la portion d'isolation supplémentaire, puis découverte après formation de la portion d'isolation supplémentaire. Cela permet de préserver cette facette pour la formation de la région source/drain.

Le procédé selon l'invention permet avantageusement de réaliser un transistor FinFet sur un substrat massif, en obtenant des performances en isolation semblables à celles obtenues sur un substrat de type « semiconducteur sur isolant », par exemple de type silicium sur isolant (SOI). Un tel substrat SOI standard coûte typiquement environ cinq fois plus cher qu'un substrat massif. Le procédé selon l'invention permet avantageusement de transformer au moins en partie un substrat massif en un substrat de type SOI, à un coût moindre.

Un deuxième aspect de l'invention concerne un dispositif microélectronique comprenant un motif de transistor supporté par un substrat,

Ledit substrat comprenant :
∘ Une portion de base en un matériau semi-conducteur présentant une face supérieure s'étendant dans un plan basal et allongée le long d'un axe longitudinal, et
∘ Des première et deuxième portions d'isolation situées de part et d'autre de ladite portion de base,

Ledit motif de transistor comprenant :
∘ au moins un canal surmontant la portion de base et s'étendant principalement le long de l'axe longitudinal,
∘ un motif de grille de transistor entourant transversalement une portion centrale de l'au moins un canal,
∘ au moins un espaceur flanquant le motif de grille de transistor et entourant transversalement une portion latérale de l'au moins un canal,
∘ une région source/drain s'étendant depuis la portion latérale de l'au moins un canal,

Ledit dispositif microélectronique comprenant en outre une portion d'isolation supplémentaire dans la portion de base, sous la région source/drain.

Avantageusement, la région source/drain du dispositif microélectronique présente une forme tronconique et n'est pas en contact avec la portion d'isolation supplémentaire. En particulier, la région source/drain n'est pas en contact électrique direct avec la portion d'isolation supplémentaire, à l'exception éventuellement d'une portion basale de la région source/drain à proximité immédiate de la portion latérale du canal.

Cela permet d'augmenter la distance séparant la région source/drain de la portion de base en un matériau semi-conducteur. L'isolation électrique de la région source/drain est améliorée. Les courants de fuite sont diminués voire supprimés. Cela permet également de former un contact ultérieur sur tout un pourtour de la région source/drain. Un tel contact permet de diminuer la résistance d'accès.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1D illustrent schématiquement des étapes de formation d'une région source/drain d'un transistor FinFET selon un procédé de l'art antérieur.
Les figures 2A à 2I illustrent schématiquement des étapes de formation d'une région source/drain d'un dispositif microélectronique selon un mode de réalisation de la présente invention.
La figure 3 illustre schématiquement un dispositif microélectronique selon un autre mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions relatives des différentes couches, portions et éléments du dispositif (par exemple espaceur, portion de base, portion d'isolation supplémentaire, région source/drain, canal) ne sont pas représentatives de la réalité.

### DESCRIPTION DÉTAILLÉE

Avant d'entamer une revue détaillée de modes de réalisation de l'invention, il est rappelé que l'invention selon son premier aspect comprend notamment les caractéristiques optionnelles ci-après pouvant être utilisées en association ou alternativement :
Selon un exemple, le canal traverse le motif de grille et les espaceurs de sorte à présenter une facette libre à chacune de ses extrémités longitudinales.

Selon un exemple, la portion d'isolation supplémentaire s'étend sous la couche de protection. Cela permet d'éviter qu'un résidu de portion de base reste exposé lors du retrait de la couche de protection.

Selon un exemple, le procédé comprend en outre, après formation de la portion d'isolation supplémentaire et avant retrait de la couche de protection, un amincissement de la portion d'isolation supplémentaire selon une direction normale au plan basal. Cela permet de compenser une augmentation de volume lors de la formation de la portion d'isolation supplémentaire par oxydation. Cela permet d'obtenir une portion d'isolation supplémentaire présentant une face supérieure correspondant sensiblement à la face supérieure de la portion de base avant mise en oeuvre du procédé.

Selon un exemple, le procédé comprend en outre, avant formation de la portion d'isolation supplémentaire et après formation de la couche de protection, une gravure sélective de la portion de base vis-à-vis des première et deuxième portions d'isolation et de la couche de protection. Selon un exemple, ladite gravure sélective est configurée pour graver le matériau semi-conducteur de la portion de base à partir de la face supérieure sur une profondeur comprise entre 2 nm et 30 nm. La gravure est ici préalable à l'oxydation. C'est une alternative à l'amincissement envisagé au paragraphe précédent. De la même manière, cela permet de compenser une augmentation de volume lors de la formation de la portion d'isolation supplémentaire par oxydation. Cela permet d'obtenir une portion d'isolation supplémentaire présentant une face supérieure correspondant sensiblement à la face supérieure de la portion de base avant mise en oeuvre du procédé.

Selon un exemple, la portion d'isolation supplémentaire s'étend au-delà de la couche de protection, sous la portion latérale du canal. Cela permet d'améliorer encore l'isolation vis-à-vis des courants de fuite.

Selon un exemple, la portion d'isolation supplémentaire s'étend sous tout le canal. Cela permet d'améliorer encore l'isolation vis-à-vis des courants de fuite.

Selon un exemple, la formation de la portion d'isolation supplémentaire se fait par oxydation thermique, ladite oxydation thermique étant configurée pour se propager principalement depuis la face supérieure le long de l'axe longitudinal.

Selon un exemple, au moins une partie de la région source/drain formée par épitaxie latérale n'est pas au contact de ou ne prend pas appui sur la portion d'isolation supplémentaire. Ainsi un espace existe entre la région source/drain formée par épitaxie latérale et la portion d'isolation supplémentaire. Cet espace peut être rempli d'un matériau diélectrique lors d'une phase ultérieure du procédé. Ainsi, l'épitaxie ne s'effectue pas à partir de la portion d'isolation supplémentaire. Il n'y a pas de contact entre la région source/drain et la portion d'isolation supplémentaire.

Selon un exemple, l'épitaxie latérale est configurée de façon à ce que la région source/drain soit au contact de la portion d'isolation supplémentaire.

Selon un exemple, l'espaceur est à base d'un premier matériau A et la couche de protection est à base d'un deuxième matériau B différent du premier matériau A.

Selon un exemple, le retrait de la couche de protection se fait par gravure sélective du deuxième matériau B vis-à-vis du premier matériau A, par exemple avec une sélectivité de gravure S_{B:A} > 5:1.

Selon un exemple, le premier matériau A est différent du deuxième matériau B.

Selon un exemple, les premier et deuxième matériaux A et B sont pris parmi un nitrure de silicium (SiₓN_{y}, x et y étant des entiers non nuls) et un boro-nitrure de silicium SiBCN.

Selon un exemple, le premier matériau A est un nitrure de silicium (SiₓN_{y}, x et y étant des entiers non nuls) et le matériau B est un oxyde de silicium (SiₓO_{y}, x et y étant des entiers non nuls) ou un boro-nitrure de silicium SiBCN.

Selon un exemple, le procédé comprend en outre une formation d'un contact métallique autour de la région source/drain.

Selon un exemple, la couche de protection prend appui sur la face supérieure de la portion de base. Elle est au contact de la portion de base. Cela permet de protéger une facette d'un canal qui s'étend depuis la région de base, au contact de celle-ci.

Selon un exemple, la facette et le flanc s'étendent sensiblement dans un même plan transverse à l'axe longitudinal.

Selon un exemple, la portion d'isolation supplémentaire présente une hauteur comprise entre 2 nm et 40 nm.

Selon un exemple, la région source/drain formée par épitaxie latérale présente une forme tronconique.

Selon un exemple, le canal est à base du matériau semi-conducteur de la portion de base du substrat.

Selon un exemple, le canal est au contact de la portion de base et présente une forme en saillie du plan basal, par exemple une forme en aileron, de sorte que l'au moins un transistor est un transistor à effet de champs à géométrie en aileron, dit FinFET.

Selon un exemple, une pluralité de canaux est formée, chaque canal présentant :
- une portion centrale entourée au moins partiellement par le motif de grille de transistor, et
- une portion latérale entourée au moins partiellement par l'au moins un espaceur et présentant une facette s'étendant transversalement à l'axe longitudinal,
- une région source/drain étant réalisée par épitaxie à partir des facettes de la pluralité de canaux.

Selon un exemple, le motif de grille de transistor entoure complètement les portions centrales des canaux de la pluralité de canaux, de sorte que l'au moins un transistor comprend une pluralité de transistors à grille enrobante, dits GAA.

L'invention selon son deuxième aspect comprend notamment les caractéristiques optionnelles ci-après pouvant être utilisées en association ou alternativement :
Selon un exemple, le dispositif comprend en outre un contact entourant la région source/drain.

Selon un exemple, le contact entoure complètement la région source/drain, autour de l'axe longitudinal.

Sauf incompatibilité, il est entendu que le dispositif et le procédé peuvent comprendre, *mutatis mutandis,* l'ensemble des caractéristiques optionnelles ci-dessus.

Dans la présente demande, on entend par « un » canal ou « un » espaceur, « au moins un » canal ou « au moins un » espaceur.

Il est précisé que dans le cadre de la présente invention, le terme « sur », « surmonte », « recouvre » ou « sous-jacent » ou leurs équivalents ne signifient pas forcément « au contact de ». Ainsi par exemple, un canal surmontant une portion de base ne signifie pas obligatoirement que le canal et la portion de base sont directement au contact l'un de l'autre, mais cela signifie que le canal recouvre au moins partiellement la portion de base en étant soit directement à son contact soit en étant séparé d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant uniquement ce matériau M, ou ce matériau M et éventuellement d'autres matériaux, par exemple des éléments d'alliage, des impuretés ou des éléments dopants. Ainsi, un espaceur à base de nitrure de silicium SiN peut par exemple comprendre du nitrure de silicium non stoechiométrique (SiN), ou du nitrure de silicium stoechiométrique (Si₃N₄), ou encore un oxy-nitrure de silicium (SiON).

En général, mais non limitativement, un espaceur forme une bague autour de la grille, avec un contour fermé ; la description d'un espaceur s'entend de préférence de cet espaceur unique autour de la grille ; cependant, les dessins d'illustration en coupe, généralement selon un plan parallèle à la direction longitudinale du canal, montrent deux parties d'espaceur de part et d'autre des flancs de la grille. Par extension, ces deux parties d'espaceur sont souvent désignées par « les espaceurs ». Cette dernière terminologie peut éventuellement être adoptée dans cette demande. Par ailleurs, l'invention s'étend aux modes de réalisation dans lesquels au moins deux espaceurs discontinus recouvrent un motif de grille.

La présente invention permet notamment la fabrication d'au moins un transistor ou d'une pluralité de transistors sur un substrat. Ce substrat est de préférence massif ou « bulk » selon la terminologie anglo-saxonne. Selon une possibilité alternative, ce substrat peut être de type semi-conducteur sur isolant, par exemple un substrat silicium sur isolant SOI (acronyme de l'anglais « silicon on insulator) ou un substrat germanium sur isolant GeOI (acronyme de l'anglais « germanium on insulator »). La portion de base, et les première et deuxième régions d'isolation sont typiquement formées dans une partie superficielle du substrat, typiquement en face avant du substrat.

L'invention peut également être mise en oeuvre plus largement pour différents dispositifs ou composants micro-électroniques.

Par composant, dispositif ou élément de dispositif microélectronique, on entend tout type d'élément réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer. Par ailleurs, le terme « étape » s'entend de la réalisation d'une partie du procédé, et peut désigner un ensemble de sous-étapes.

Le terme « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7. Les espaceurs sont typiquement formés en un matériau diélectrique.

Les termes « motif de grille », « empilement de grille », « grille » sont employés en synonymes.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B.

Dans la présente demande de brevet, on parlera préférentiellement d'épaisseur pour une couche, de hauteur pour un dispositif (transistor ou grille par exemple) et de profondeur pour une cavité ou une gravure. L'épaisseur est prise selon une direction normale au plan d'extension principale de la couche, la hauteur et la profondeur sont prises selon une direction normale au plan de base du substrat. Le plan d'extension principale de la couche, respectivement le plan de base du substrat, est généralement parallèle à une face inférieure ou une face supérieure de cette couche, respectivement de ce substrat.

Dans la présente demande de brevet, un repère de préférence orthonormé formé par les axes x, y, z est représenté sur les dessins d'accompagnement. Le substrat, plus précisément sa face inférieure et/ou sa face supérieure, s'étendent dans le plan basal xy.

Dans la suite, la longueur est prise selon la direction portée par l'axe x, dit axe longitudinal, la largeur est prise selon la direction portée par l'axe y.

Un élément situé « à l'aplomb » ou « au droit d'» un autre élément signifie que ces deux éléments sont situés tous deux sur une même ligne perpendiculaire au plan basal, soit sur une même ligne orientée selon l'axe z sur les figures.

On entend par « horizontale » une orientation parallèle à un plan xy. On entend par « verticale » une orientation parallèle à l'axe z.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de 90±10° par rapport au plan.

L'invention va maintenant être décrite en détail au travers de quelques modes de réalisation non limitatifs.

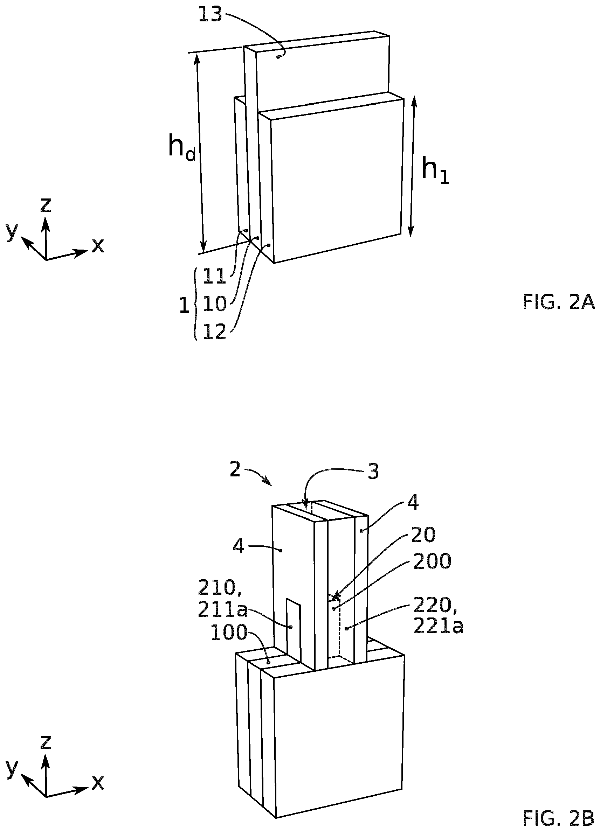

Un premier mode de réalisation du procédé est illustré aux figures 2A-2H.

Ce procédé est de préférence mis en oeuvre sur une structure initiale comprenant un substrat 1 et un aileron 13, telle qu'illustrée à la figure 2A par exemple.

Une telle structure peut typiquement être obtenue à partir d'un substrat massif en silicium. Dans ce cas, le substrat massif est gravé sur une profondeur h_{d} comprise entre quelques dizaines de nanomètres et quelques centaines de nanomètres, pour former un mur fin en silicium de hauteur h_{d}. Des portions d'isolation 11, 12 sont ensuite formées de part et d'autre du mur fin, par exemple par dépôt d'oxyde de silicium, sur une hauteur h₁ < h_{d}. La portion du mur fin située entre les portions d'isolation 11, 12 est dite portion de base 10. La portion de base 10 présente ainsi une hauteur h₁. La portion de base 10 forme avec les portions d'isolations 11, 12 le substrat 1. Les faces exposées des portions d'isolation 11, 12, dans le plan xy, définissent ainsi le plan basal du substrat 1.

La portion du mur fin restée libre, en saillie du plan basal et surmontant la portion de base 10, est appelée aileron 13. L'aileron 13 présente ainsi une hauteur h_{d} - h₁. Le mur fin comprend ici la portion de base 10 et l'aileron 13, comme illustré à la figure 2A. L'aileron 13 présente typiquement une dimension longitudinale L₂₀ selon x de l'ordre de plusieurs dizaines de nanomètres par exemple 10 nm ≤ L₂₀ ≤ 200 nm, et une dimension transverse W₂₀ selon y de l'ordre de quelques nanomètres, par exemple 5 nm ≤ W₂₀ ≤ 30 nm. La portion de base 10 présente typiquement une dimension longitudinale L₁₀ selon x de l'ordre de plusieurs dizaines de nanomètres, par exemple 10 nm ≤ L₁₀ ≤ 200 nm, et une dimension transverse W₁₀ selon y de l'ordre de quelques nanomètres, par exemple 5 nm ≤ W₁₀ ≤ 30 nm. Les dimensions longitudinales sont de préférence égales, soit L₁₀ = L₂₀. Les dimensions transverses peuvent être égales, soit W₁₀ = W₂₀. Alternativement, la dimension transverse W₂₀ de l'aileron 13 peut varier le long de sa hauteur, typiquement elle peut diminuer depuis la base de l'aileron 13 attachée à la portion de base 10, jusqu'au sommet de l'aileron 13. L'aileron 13 présente ainsi une section transverse, dans un plan normal à la direction longitudinale x, de forme pyramidale ou tronconique. La dimension transverse W₁₀ de la portion de base 10 peut varier le long de sa hauteur h₁. La portion de base 10 peut typiquement présenter une section transverse pyramidale ou tronconique.

Selon une autre possibilité, le mur fin peut être à base de silicium-germanium SiGe.

Comme illustré à la figure 2B, l'aileron 13 est ensuite structuré de manière à former un canal 20 d'un motif de transistor 2. Ce canal 20 comprend typiquement ici une portion centrale 200 et deux portions latérales 210, 220 de part et d'autre de la portion centrale 200. Un motif de grille 3 est typiquement formé à cheval sur l'aileron 13, de manière à définir la portion centrale 200 du canal 20. De façon connue, ce motif de grille 3 peut être une grille fonctionnelle telle que mise en oeuvre dans des procédés de type « gate first » (la grille est conservée à l'issue de la réalisation des espaceurs), ou une grille sacrificielle telle que mise en oeuvre dans des procédés de type « gate last » (la grille est remplacée à l'issue de la réalisation des espaceurs).

Le motif de grille 3 s'étend principalement de façon transverse à l'axe longitudinal x. Il peut prendre appui sur les portions d'isolation 11, 12, de part et d'autre de la portion centrale 200 du canal 20.

Le motif de grille 3 est typiquement flanqué par un ou plusieurs espaceurs 4. Ces espaceurs 4 sont formés à cheval sur l'aileron 13, de manière à définir les portions latérales 210, 220 du canal 20. Les espaceurs 4 s'étendent principalement de façon transverse à l'axe longitudinal x. Ils peuvent prendre appui sur les portions d'isolation 11, 12, de part et d'autre des portions latérales 210, 220 du canal 20. Les espaceurs 4 sont de préférence directement au contact du motif de grille 3. Ils présentent une épaisseur L₄ selon x, de préférence environ constante, et par exemple comprise entre 2 nm et 10 nm. Les espaceurs 4 sont typiquement à base de nitrure de silicium SiN ou de SiBCN ou de SiCO.

Après formation du motif de grille 3 et des espaceurs 4, les portions exposées de l'aileron 13 sont gravées, par exemple par gravure anisotrope selon z. Cette gravure anisotrope est de préférence configurée pour s'arrêter sur une face supérieure 100 de la portion de base 10. À l'issue de cette gravure anisotrope, les portions latérales 210, 220 présentent respectivement des facettes exposées 211a, 221a. Ces facettes 211a, 221a peuvent s'étendre sensiblement dans le même plan yz que les flancs 411, 421 des espaceurs 4. Le canal 20 traverse ainsi le motif de grille 3 et les espaceurs 4 de sorte à présenter une facette 211a, 221a libre à chacune de ses extrémités longitudinales.

Le motif de transistor 2 comprend ici le motif de grille 3, les espaceurs 4, et les portions centrale 200 et latérales 210, 220 du canal 20. Le motif de transistor 2 peut également comprendre un masque dur sur le motif de grille et les espaceurs, au sommet du motif de transistor (non illustré). Ce motif de transistor 2 correspond typiquement à une architecture de transistor dit « FinFET ». Le motif de transistor 2 surmonte le substrat 1. Une face supérieure 100 de la portion de base 10 est exposée.

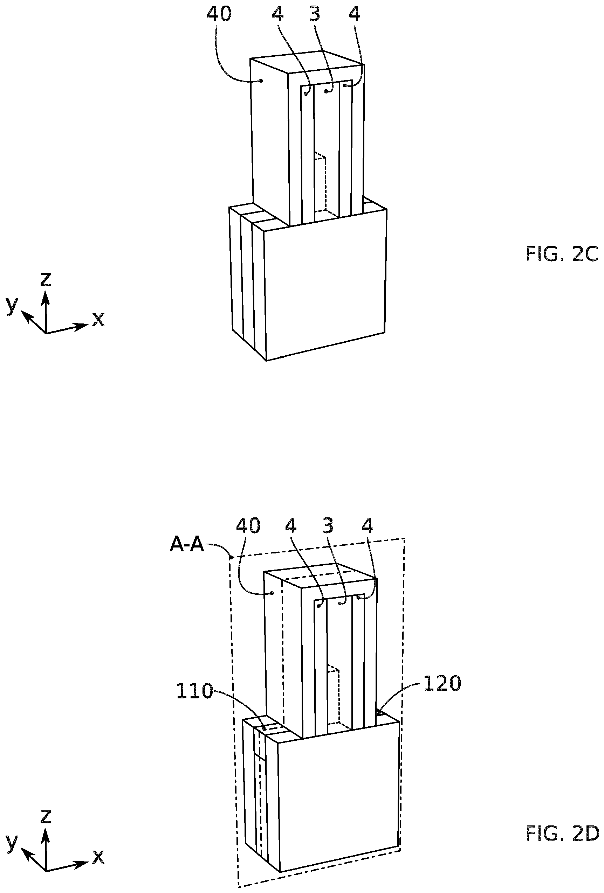

Après structuration ou fourniture du motif de transistor 2, une couche de protection 40 est formée, comme illustré à la figure 2C. Cette couche de protection 40 couvre de préférence les flancs des espaceurs 4, le sommet du motif de transistor 2, et les facettes 211a, 221a. Cela permet notamment de protéger les facettes 211a, 221a lors de l'étape d'oxydation ultérieure. La couche de protection 40 présente une épaisseur L₄₀ de préférence environ constante, et par exemple comprise entre 1 nm et 10 nm. La couche de protection 40 peut typiquement être déposée de façon conforme sur le motif de transistor 2, par exemple par Atomic Layer Déposition (ALD) ou dépôt chimique en phase vapeur (CVD). Elle est ensuite gravée de façon à exposer une partie de la face supérieure 100 de la portion de base 10. La couche de protection 40 peut être à base de boro-nitrure de silicium SiBCN. Selon une autre possibilité, la couche de protection 40 peut être à base d'oxyde de silicium. La couche de protection 40 est de préférence en un matériau différent du matériau des espaceurs 4. Cela permettra ensuite de retirer la couche de protection 40 sélectivement, sans endommager les espaceurs 4.

La figure 2D illustre la formation des portions d'isolation supplémentaires 110, 120 dans le substrat 1, après formation de la couche de protection 40 sur le motif de transistor 2. Ces portions d'isolation supplémentaires 110, 120 sont de préférence réalisées par oxydation thermique du matériau semi-conducteur de la portion de base 10 du substrat 1. De façon connue, l'oxydation thermique peut par exemple se faire à une température comprise entre 750 et 1050 °C. Le lecteur peut se référer au document « The physics and chemistry of SiO2 and the Si-SiO2 interface, Helms and Deal, 1988 » pour déterminer les conditions d'oxydation, par exemple tel qu'enseigné aux pages 17 à 23 de ce document. Cette oxydation se fait à partir de la face supérieure 100 exposée de la portion de base 10. Elle se propage au sein de la portion de base 10 pour former les portions d'isolation supplémentaires 110, 120 sous la face supérieure 100. La face supérieure 100 devient une face supérieure 100 des portions d'isolation supplémentaires 110, 120.

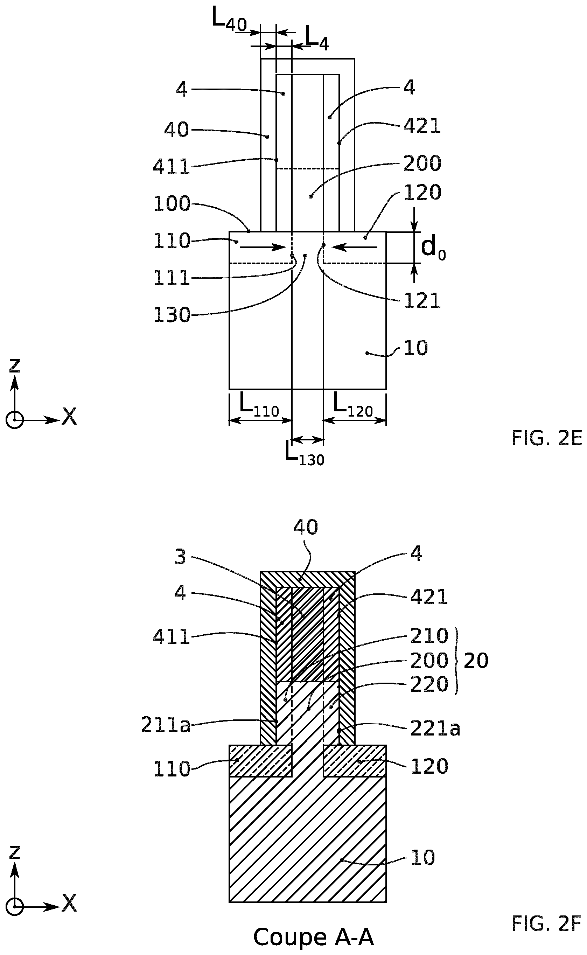

Comme illustré à la figure 2E, les fronts d'oxydation 111, 121 progressent aussi selon x. Ainsi, les portions d'isolation supplémentaires 110, 120 peuvent se former sous la couche de protection 40, et de préférence sous les espaceurs 4. Une partie 130 de la portion de base 10 peut subsister sensiblement sous la partie centrale 200 du canal 20, entre les portions d'isolation supplémentaires 110, 120. Toutefois, cette partie qui subsiste peut-être à l'origine de courants de fuite depuis les futures régions de source et drain vers le substrat. Ainsi, L₁₃₀ est de préférence inférieure à la distance, mesurée selon l'axe x, séparant les flancs 411, 421 des espaceurs 4, de préférence L₁₃₀ est nulle. Selon un mode de réalisation, L₁₃₀ est de préférence inférieure à la dimension, mesurée selon l'axe x, du motif de grille 3.

Les portions d'isolation supplémentaires 110, 120 ainsi formées présentent de préférence une hauteur dₒ correspondant à la profondeur d'oxydation, et respectivement des longueurs L₁₁₀, L₁₂₀. La profondeur d'oxydation dₒ est de préférence comprise entre 2 nm et 20 nm. Les longueurs L₁₁₀, L₁₂₀ sont de préférence comprises entre 10 nm et 100 nm. La partie 130 peut présenter une longueur L₁₃₀ comprise entre 0 nm et 50 nm. Dans le cas où le substrat porte des motifs de transistors densément distribués, les longueurs L₁₁₀, L₁₂₀ peuvent en partie dépendre de l'espacement entre deux motifs de transistors adjacents.

Comme illustré à la figure 2F en coupe selon le plan A-A' représenté sur la figure 2D, les portions d'isolation supplémentaires 110, 120 s'avancent de préférence sous les portions latérales 210, 220 du canal 20, et de préférence sous la portion centrale 200 du canal 20.

Selon une autre possibilité, les fronts d'oxydation 111, 121 se rejoignent sensiblement sous la portion centrale 200 du canal, de sorte que le canal 20 est totalement isolé vis-à-vis de la portion de base 10. Ainsi, L₁₃₀ =0. Selon cette possibilité préférée, les portions d'isolation supplémentaires 110, 120 forment une portion continue sous le canal. Les conditions d'oxydation sont choisies de manière à ce que la longueur L₁₃₀ de la partie 130 soit la plus petite possible, et de préférence de manière à ce que la longueur L₁₃₀ de la partie 130 soit nulle. Cela permet de limiter voire de supprimer les courants de fuite depuis les régions source et drain vers le substrat.

Un amincissement des portions d'isolation supplémentaires 110, 120 selon la direction z est de préférence effectué. Cela permet de compenser une augmentation de volume lors de la formation des portions d'isolation supplémentaires 110, 120 par oxydation. L'amincissement peut être configuré de façon à ce que les portions d'isolation supplémentaires présentent une face supérieure correspondant sensiblement à la face supérieure 100 de la portion de base 10 avant oxydation. Selon une autre possibilité, l'amincissement peut être poursuivi de façon à ce que les portions d'isolation supplémentaires présentent une face supérieure située sous la face supérieure 100 de la portion de base 10 avant oxydation. Cela permet d'augmenter le volume des régions source/drain. Cela permet dès lors de diminuer la résistance d'accès au transistor. Cet amincissement peut être effectué par gravure anisotrope selon z.

Selon une possibilité alternative ou en combinaison à l'amincissement, la portion de base 10 peut être gravée préalablement à la formation des portions d'isolation supplémentaires 110, 120, de façon à abaisser localement le niveau de la face supérieure 100. Cela permet de prendre en compte l'augmentation de volume due à l'oxydation, lors de la formation des portions d'isolation supplémentaires 110, 120. Cette gravure de la portion de base 10 est typiquement sélective vis-à-vis des portions d'isolation 11, 12. Ainsi, seule la portion de base 10 est gravée. Les portions d'isolation 11, 12 restent sensiblement inchangées. Cette gravure de la portion de base 10 peut se faire sur une profondeur selon z de quelques nanomètres à quelques dizaines de nanomètres, par exemple entre 2 nm et 30 nm. Les portions d'isolation supplémentaires 110, 120 peuvent alors être ensuite formées.

Après formation des portions d'isolation supplémentaires 110, 120, la couche de protection 40 est retirée de manière à exposer de nouveau les facettes 211a, 221a des portions latérales 210, 220 du canal. Le retrait de la couche de protection 40 se fait de préférence par gravure sélective de la couche de protection 40 vis-à-vis des espaceurs 4. Cette gravure sélective peut présenter une sélectivité de gravure S_{B:A} du matériau B de la couche de protection vis-à-vis du matériau A des espaceurs, supérieure à 5:1. Cette gravure sélective présente également de préférence une sélectivité de gravure S_{B:C} du matériau B de la couche de protection vis-à-vis du matériau C des portions d'isolation supplémentaires, supérieure à 5:1. Cette gravure sélective présente également de préférence une sélectivité de gravure S_{B:D} du matériau B de la couche de protection vis-à-vis du matériau semi-conducteur D des portions latérales du canal, supérieure à 5:1. La couche de protection 40 est ainsi retirée sans endommager ou sans enlever complètement les espaceurs 4 et/ou les portions d'isolation supplémentaires 110, 120 et/ou les portions latérales 210, 220 du canal 20.

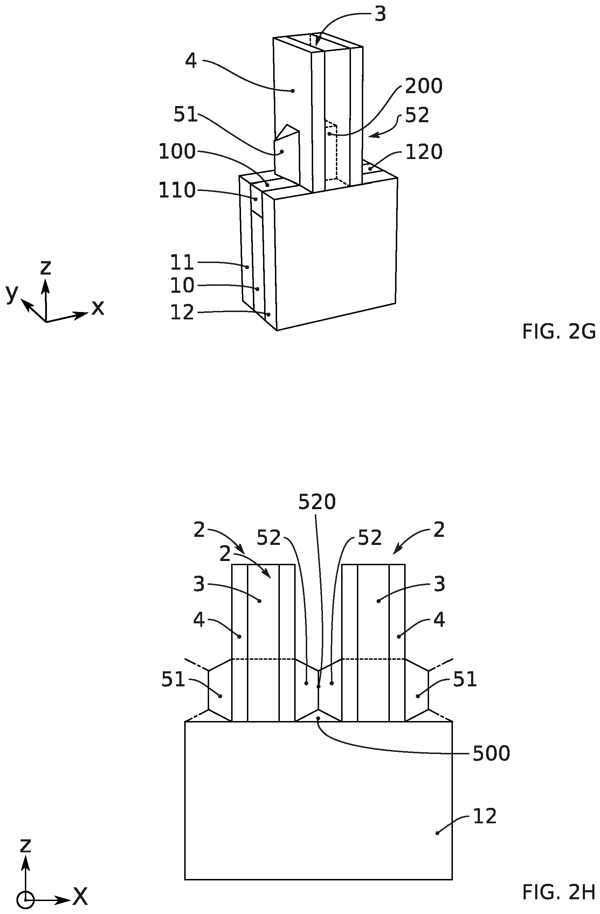

Comme illustré à la figure 2G, après retrait de la couche de protection 40, un procédé d'épitaxie sélective dopée *in situ* est mis en oeuvre pour former les régions source/drain 51, 52 à partir des portions latérales 210, 220 du canal 20. Un dopage bore ( :B) ou phosphore ( :P) peut ainsi être obtenu. Les régions source/drain 51, 52 peuvent être par exemple à base de Si:P, Si:B ou SiGe:B. Cette épitaxie des régions source/drain 51, 52 se fait latéralement à partir des facettes 211a, 221a exposées. La croissance epitaxiale est ainsi dans un premier temps principalement dirigée selon x. La face supérieure 100 des portions d'isolation supplémentaires 110, 120 evite la croissance épitaxiale des régions source/drain 51, 52 à partir de la portion de base 10.

Selon une possibilité, les régions source/drain 51, 52 ne sont pas en contact et/ou ne prennent pas appui sur la face supérieure 100 des portions d'isolation supplémentaires 110, 120. Ainsi un espace ou une distance non nulle existe entre la région source/drain 51, 52 et la face supérieure 100 des portions d'isolation supplémentaires 110, 120. Cet espace peut être rempli d'un matériau diélectrique lors d'une phase ultérieure du procédé.

Les régions source/drain 51, 52 tendent ainsi à adopter une forme tronconique, comme illustré à la figure 2G. En particulier, la section transverse des régions source/drain 51, 52 diminue en s'éloignant des facettes 211a, 221a. Cette section transverse des régions source/drain 51, 52, prise dans un plan transverse yz, peut notamment présenter une surface régulièrement décroissante. Selon une possibilité, seule une portion négligeable des régions source/drain, située à proximité immédiate des facettes 211a, 221a, est en contact avec la face supérieure 100 des portions d'isolation supplémentaires 110, 120. Une telle portion négligeable présente typiquement une surface de contact avec la face supérieure 100 inférieure de 20 % de la surface projetée des régions source/drain 51, 52 sur la face supérieure 100.

Un dégagement ou une cavité 500 peut ainsi être formé(e) sous les régions source/drain 51, 52, entre les régions source/drain 51, 52 et les portions d'isolation supplémentaires 110, 120. Cela permettra ensuite de former un contact enrobant entourant une partie au moins des régions source/drain 51, 52, en remplissant ce dégagement ou cette cavité 500.

Selon une autre possibilité, cette cavité 500 est remplie par le matériau d'épitaxie des régions source/drain 51, 52.

Comme illustré à la figure 2H, le substrat 1 peut porter une pluralité de motifs de transistors 2 adjacents. Lors de la formation des régions source/drain 51, 52 par épitaxie latérale, les régions source/drain 51, 52 issues de deux motifs de transistors 2 adjacents peuvent se rejoindre, par exemple au niveau d'une interface 520 (figure 2H). Dans cet exemple, les sommets de deux drains 52 se rejoignent au niveau de l'interface 520 et une cavité 500 est formée sous les drains 52. En prolongeant l'épitaxie latérale des régions source/drain 51, 52 après que celles-ci se soient fusionnées, la cavité 500 peut être remplie par le matériau d'épitaxie des régions source/drain 51, 52.

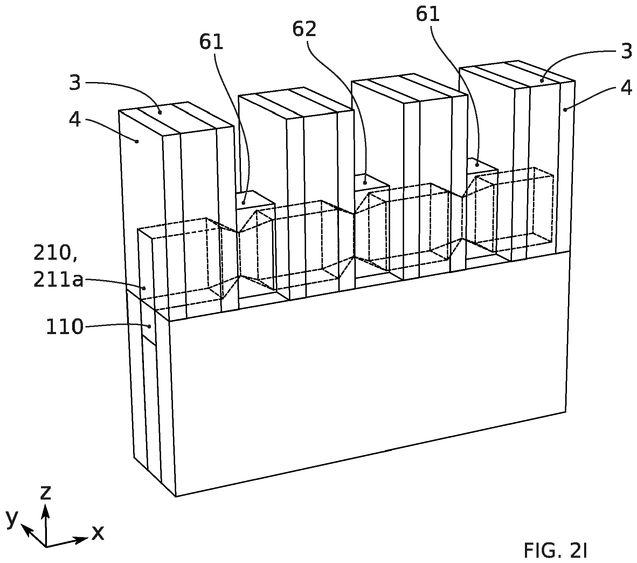

Comme illustré à la figure 2I, des contacts 61, 62 peuvent être ensuite formés autour des régions source/drain 51, 52. Ces contacts sont de préférence formés de manière à entourer complètement les régions source/drain 51, 52, de préférence en remplissant les dégagements et cavités 500. Cela permet d'augmenter la surface de contact entre les contacts 61, 62 et respectivement les régions source/drain 51, 52. Cela permet avantageusement de diminuer la résistance d'accès au niveau du contact. Les contacts 61/62 peuvent prendre appui sur la face supérieure 100 des portions d'isolation supplémentaires 110, 120.

Le procédé est ainsi particulièrement adapté à la formation de régions source/drain de transistors FinFET, comme illustré au travers de ce premier mode de réalisation. Le procédé peut également être mis en oeuvre pour d'autres architectures de transistors. Le canal en Si peut ainsi être remplacé par un empilement Si/SiGe en configuration FinFET.

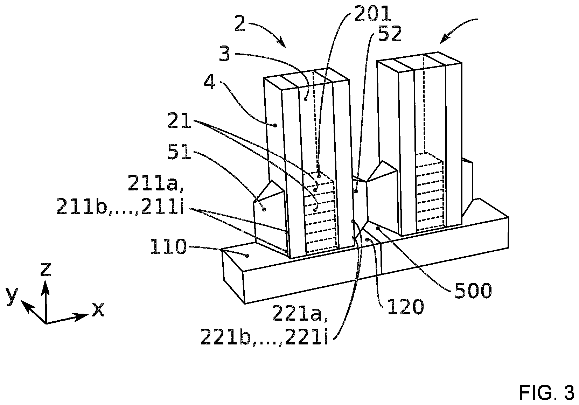

Selon un deuxième mode de réalisation illustré aux figures 3A, 3B, le procédé est mis en oeuvre sur des transistors de type « Gate All Around » GAA (transistors à grille enrobante). Dans ce mode de réalisation, un empilement de canaux 21 est réalisé en lieu et place du canal 20 du précédent mode de réalisation. Seules les caractéristiques différentes du premier mode de réalisation sont décrites ci-après, les autres caractéristiques non décrites étant réputées identiques. Ainsi, préalablement à la gravure profonde du substrat massif permettant de former le mur fin, un empilement de couches semi-conductrices alternées avec des couches sacrificielles est formé sur le substrat massif.

Cet empilement est ensuite gravé de manière à former la portion du mur fin en saillie du plan basal du substrat. Cette portion en saillie comprend les canaux 21 issus des couches semi-conductrices, et des séparateurs issus des couches sacrificielles. Une grille sacrificielle est ensuite formée à cheval sur cette portion en saillie, au niveau d'une partie centrale 201 de la portion en saillie. Des espaceurs 4 sont formés comme précédemment de part et d'autre de la grille sacrificielle, au niveau de parties latérales de la portion en saillie.

Une gravure anisotrope permet ensuite d'exposer des facettes 211a, 211b, ..., 211i et 221a, 221b, ..., 221i pour chaque canal 21 de la portion en saillie, ainsi qu'une face supérieure 100 dans le plan basal du substrat.

Selon un principe de formation des transistors à grille enrobante GAA, les séparateurs sont typiquement retirés puis remplacés en deux étapes. Les séparateurs sont d'abord retirés partiellement au niveau des parties latérales de la portion en saillie. Des cavités bordées par les espaceurs 4 sont ainsi formées dans la portion en saillie. Ces cavités sont alors remplies par un matériau diélectrique, puis arasées par gravure de manière à former des bouchons diélectriques aux extrémités des séparateurs.

A ce stade, le motif de transistor 2 comprend la grille sacrificielle, les espaceurs 4, les canaux 21, les séparateurs au niveau de la partie centrale 201 et les bouchons au niveau des parties latérales de la portion en saillie.

Une grille fonctionnelle enrobante 3 est formée autour des canaux 21. Lors du retrait des séparateurs, les espaceurs 4 permettent notamment de soutenir les canaux 21. Un tel motif de transistor 2 correspond typiquement à une architecture de transistor dit « GAA ».

Comme précédemment, une couche de protection peut être déposée sur le motif de transistor 2 ainsi formé. Cette couche de protection peut correspondre au dépôt effectué pour former les bouchons au niveau des parties latérales de la portion en saillie. Les portions d'isolation supplémentaires 110, 120 peuvent ensuite être formées. La couche de protection est ensuite retirée de façon à exposer les facettes 211a-211i, 221a-221i. Les régions source/drain 51, 52 sont alors formées par épitaxie latérale à partir des facettes 211a-211i, 221a-221i. Il en résulte que ces régions source/drain présentent une forme tronconique, définissant une cavité 500 avec le substrat. Cela permet d'augmenter la barrière diélectrique vis-à-vis du substrat et de diminuer les courants de fuite. Cela permet ensuite de former un contact enrobant sur les régions source/drain 51, 52. Un tel contact enrobant permet avantageusement de diminuer la résistance d'accès aux régions source/drain 51, 52. Cette cavité 500 peut aussi, par exemple, être remplie d'un matériau diélectrique lors d'une phase ultérieure du procédé.

Les séparateurs peuvent ensuite être retirés au niveau de la partie centrale de la portion en saillie. De façon classique, la grille sacrificielle est retirée, puis les séparateurs sont retirés et Le procédé est ainsi particulièrement adapté à la formation de régions source/drain de transistors GAA. La présente invention concerne également un dispositif tel que décrit au travers des exemples de réalisation précédents.

L'invention n'est pas limitée aux modes de réalisations précédemment décrits et s'étend à tous les modes de réalisation couverts par les revendications. Le canal en Si du premier mode de réalisation peut ainsi être remplacé par un canal SiGe, ou par un empilement Si/SiGe en configuration FinFET.

## Revendications

1. Procédé de formation d'au moins une région source/drain (51, 52) d'au moins un transistor, comprenant les étapes suivantes :
- Fournir un substrat (1) massif portant un motif de transistor (2),
Ledit substrat (1) massif comprenant :
∘ Une portion de base (10) en un matériau semi-conducteur présentant une face supérieure (100) s'étendant dans un plan basal et allongée le long d'un axe longitudinal (x), et
∘ Des première et deuxième portions d'isolation (11, 12) situées de part et d'autre de ladite portion de base (10),
Ledit motif de transistor (2) comprenant :
∘ un canal (20, 21) surmontant la portion de base (10) et s'étendant notamment le long de l'axe longitudinal (x),
∘ un motif de grille de transistor (3) entourant une portion centrale (200) du canal (20, 21), le motif de grille (3) présentant un flanc,
∘ un espaceur (4) recouvrant le flanc du motif de grille (3) et entourant transversalement une portion latérale (210, 220) du canal (20, 21),
la portion latérale (210, 220) du canal (20) et l'espaceur (4) présentant respectivement une facette (211a-211i, 221a-221i) et un flanc (411, 421) s'étendant transversalement à l'axe longitudinal (x),
- Former une portion d'isolation supplémentaire (110, 120) dans la portion de base (10), par oxydation du matériau semi-conducteur à partir de la face supérieure (100) de la portion de base (10),
- Former par épitaxie sélective une région source/drain (51, 52) à partir de ladite facette (211a-211i, 221a-221i) du canal (20),
Le procédé étant **caractérisé en ce qu'**il comprend en outre les étapes suivantes :
- Avant formation de la portion d'isolation supplémentaire (110, 120), former une couche de protection (40) sur la facette (211a-211i, 221a-221i) du canal (20), ladite couche de protection (40) étant configurée pour empêcher une oxydation de la portion latérale (210, 220) du canal (20) lors de la formation par oxydation de la portion d'isolation supplémentaire (110, 120),
- Après formation de la portion d'isolation supplémentaire (110, 120) et avant formation de la région source/drain (51, 52), retirer la couche de protection (40) de façon à exposer la facette (211a-211i, 221a-221i).

2. Procédé selon la revendication précédente dans lequel la portion d'isolation supplémentaire (110, 120) s'étend sous la couche de protection (40).

3. Procédé selon l'une quelconque des revendications précédentes comprenant en outre, après formation de la portion d'isolation supplémentaire (110, 120) et avant retrait de la couche de protection (40), un amincissement de la portion d'isolation supplémentaire (110, 120) selon une direction normale au plan basal.

4. Procédé selon l'une quelconque des revendications 1 ou 2 comprenant en outre, avant formation de la portion d'isolation supplémentaire (110, 120) et après formation de la couche de protection (40), une gravure sélective de la portion de base (10) vis-à-vis des première et deuxième portions d'isolation (11, 12) et de la couche de protection (40), ladite gravure sélective étant configurée pour graver le matériau semi-conducteur de la portion de base (10) à partir de la face supérieure (100) sur une profondeur comprise entre 2 nm et 30 nm.

5. Procédé selon l'une quelconque des revendications précédentes dans lequel la portion d'isolation supplémentaire (110, 120) s'étend au-delà de la couche de protection (40), sous la portion latérale (210, 220) du canal.

6. Procédé selon l'une quelconque des revendications précédentes dans lequel la portion d'isolation supplémentaire (110, 120) s'étend sous tout le canal (20).

7. Procédé selon l'une quelconque des revendications précédentes dans lequel la formation de la portion d'isolation supplémentaire (110, 120) se fait par oxydation thermique, ladite oxydation thermique étant configurée pour se propager principalement depuis la face supérieure (100), principalement le long de l'axe longitudinal (x).

8. Procédé selon l'une quelconque des revendications précédentes dans lequel au moins une partie de la région source/drain (51, 52) formée par épitaxie latérale n'est pas au contact de la portion d'isolation supplémentaire (110, 120).

9. Procédé selon l'une quelconque des revendications 1 à 7 dans lequel l'épitaxie latérale est configurée de façon à ce que la région source/drain (51, 52) soit au contact de la portion d'isolation supplémentaire (110, 120).

10. Procédé selon l'une quelconque des revendications précédentes comprenant en outre une formation d'un contact (61, 62) métallique entourant la région source/drain (51, 52).

11. Procédé selon l'une quelconque des revendications précédentes dans lequel la couche de protection (40) prend appui sur la face supérieure (100) de la portion de base (10).

12. Procédé selon l'une quelconque des revendications précédentes dans lequel la facette (211a-211i, 221a-221i) et le flanc (411, 421) s'étendent sensiblement dans un même plan, transverse à l'axe longitudinal (x).

13. Procédé selon l'une quelconque des revendications précédentes dans lequel le canal (20) est au contact de la portion de base (10) et présente une forme en saillie du plan basal, par exemple une forme en aileron, de sorte que l'au moins un transistor est un transistor à effet de champs à géométrie en aileron, dit FinFET.

14. Procédé selon l'une quelconque des revendications précédentes dans lequel une pluralité de canaux (21) est formée, chaque canal présentant :
- une portion centrale entourée au moins partiellement par le motif de grille de transistor, et
- une portion latérale entourée au moins partiellement par l'espaceur (4) et présentant une facette (211a-211i, 221a-221i) s'étendant transversalement à l'axe longitudinal (x),
- une région source/drain (51, 52) étant réalisée par épitaxie à partir des facettes (211a-211i, 221a-221i) de la pluralité de canaux (21).

15. Procédé selon l'une quelconque des revendications précédentes dans lequel la région source/drain (51, 52) est formée par épitaxie sélective uniquement à partir de ladite facette (211a-211i, 221a-221i) du canal (20).

## Patentansprüche

1. Verfahren zur Bildung mindestens eines Source/Drain-Bereichs (51, 52) mindestens eines Transistors, die folgenden Schritte umfassend:
- Bereitstellen eines massiven Substrats (1), das ein Transistormuster (2) trägt,
wobei das massive Substrat (1) umfasst:
∘ einen Basisabschnitt (10) aus einem Halbleitermaterial, der eine Oberseite (100) aufweist, die sich in einer Grundebene erstreckt und entlang einer Längsachse (x) verlängert ist, und
∘ erste und zweite Isolationsabschnitte (11, 12), die auf beiden Seiten des Basisabschnitts (10) angeordnet sind,
wobei das Transistormuster (2) umfasst:
∘ einen Kanal (20, 21), der den Basisabschnitt (10) überragt und sich insbesondere entlang der Längsachse (x)erstreckt,
∘ ein Transistor-Gate-Muster (3), das einen zentralen Abschnitt (200) des Kanals (20, 21) umgibt, wobei das Gate-Muster (3) eine Flanke aufweist,
∘ einen Abstandshalter (4), der die Flanke des Gate-Musters (3) bedeckt, und einen seitlichen Abschnitt (210, 220) des Kanals (20, 21) quer umgibt,
wobei der seitliche Abschnitt (210, 220) des Kanals (20) und der Abstandshalter (4) jeweils eine Facette (211a-211i, 221a-221i) und eine Flanke (411, 421) aufweisen, die sich quer zur Längsachse (x) erstrecken,
- Bilden eines zusätzlichen Isolationsabschnitts (110, 120) im Basisabschnitt (10) durch Oxidation des Halbleitermaterials von der Oberseite (100) des Basisabschnitts (10) ausgehend,
- Bilden, durch selektive Epitaxie, eines Source/Drain-Bereichs (51, 52) von der Facette (211a-211i, 221a-221i) des Kanals (20) ausgehend,
wobei das Verfahren **dadurch gekennzeichnet ist, dass** es ferner die folgenden Schritte umfasst:
- vor der Bildung des zusätzlichen Isolationsabschnitts (110, 120), Bilden einer Schutzschicht (40) auf der Facette (211a-211i, 221a-221i) des Kanals (20), wobei die Schutzschicht (40) konfiguriert ist, um eine Oxidation des seitlichen Abschnitts (210, 220) des Kanals (20) während der Bildung des zusätzlichen Isolationsabschnitts (110, 120) durch Oxidation zu verhindern,
- nach der Bildung des zusätzlichen Isolationsabschnitts (110, 120) und vor der Bildung des Source/Drain-Bereichs (51, 52), Entfernen der Schutzschicht (40), um die Facette (211a-211i, 221a-221i) freizulegen.

2. Verfahren nach dem vorhergehenden Anspruch, wobei sich der zusätzliche Isolationsabschnitt (110, 120) unter der Schutzschicht (40) erstreckt.

3. Verfahren nach einem der vorhergehenden Ansprüche, das ferner, nach der Bildung des zusätzlichen Isolationsabschnitts (110, 120) und vor dem Entfernen der Schutzschicht (40), eine Ausdünnung des zusätzlichen Isolationsabschnitts (110, 120) entlang einer zur Grundebene senkrechten Richtung umfasst.

4. Verfahren nach einem der Ansprüche 1 oder 2, das ferner, vor der Bildung des zusätzlichen Isolationsabschnitts (110, 120) und nach der Bildung der Schutzschicht (40), ein selektives Ätzen des Basisabschnitts (10) gegenüber dem ersten und zweiten Isolationsabschnitt (11, 12) und der Schutzschicht (40) umfasst, wobei das selektive Ätzen konfiguriert ist, um das Halbleitermaterial des Basisabschnitts (10) ausgehend von der Oberseite (100) in einer Tiefe von 2 nm bis 30 nm zu ätzen.

5. Verfahren nach einem der vorhergehenden Ansprüche, wobei sich der zusätzliche Isolationsabschnitt (110, 120) über die Schutzschicht (40) hinaus erstreckt, unterhalb des seitlichen Abschnitts (210, 220) des Kanals.

6. Verfahren nach einem der vorhergehenden Ansprüche, wobei sich der zusätzliche Isolationsabschnitt (110, 120) unter dem gesamten Kanal (20) erstreckt.

7. Verfahren nach einem der vorhergehenden Ansprüche, wobei die Bildung des zusätzlichen Isolationsabschnitts (110, 120) durch thermische Oxidation erfolgt, wobei die thermische Oxidation konfiguriert ist, um sich grundsätzlich von der Oberseite (100) aus, grundsätzlich entlang der Längsachse (x) auszubreiten.

8. Verfahren nach einem der vorhergehenden Ansprüche, wobei mindestens ein Teil des durch seitliche Epitaxie gebildeten Source/Drain-Bereichs (51, 52) nicht mit dem zusätzlichen Isolationsabschnitt (110, 120) in Kontakt steht.

9. Verfahren nach einem der Ansprüche 1 bis 7, wobei die seitliche Epitaxie so konfiguriert ist, dass der Source/Drain-Bereich (51, 52) mit dem zusätzlichen Isolationsabschnitt (110, 120) in Kontakt steht.

10. Verfahren nach einem der vorhergehenden Ansprüche, ferner eine Bildung eines metallischen Kontakts (61, 62) umfassend, der den Source/Drain-Bereich (51, 52) umgibt.

11. Verfahren nach einem der vorhergehenden Ansprüche, wobei die Schutzschicht (40) auf der Oberseite (100) des Basisabschnitts (10) aufliegt.

12. Verfahren nach einem der vorhergehenden Ansprüche, wobei sich die Facette (211a-211i, 221a-221i) und die Flanke (411, 421) im Wesentlichen in derselben Ebene erstrecken, quer zur Längsachse (x).

13. Verfahren nach einem der vorhergehenden Ansprüche, wobei der Kanal (20) in Kontakt mit dem Basisabschnitt (10) steht und eine Form aufweist, die von der Grundebene vorsteht, beispielsweise eine Rippenform, so dass der mindestens eine Transistor ein Feldeffekttransistor mit Rippengeometrie ist, FinFET genannt.

14. Verfahren nach einem der vorhergehenden Ansprüche, wobei eine Vielzahl von Kanälen (21) gebildet wird, wobei jeder Kanal aufweist:
- einen zentralen Abschnitt, der mindestens teilweise vom Transistor-Gate-Muster umgeben ist, und
- einen seitlichen Abschnitt, der mindestens teilweise vom Abstandshalter (4) umgeben ist und eine Facette (211a-211i, 221a-221i) aufweist, die sich quer zur Längsachse (x) erstreckt,
- einen Source/Drain-Bereich (51, 52), der durch Epitaxie ausgehend von den Facetten (211a-211i, 221a-221i) der Vielzahl von Kanälen (21) hergestellt wird.

15. Verfahren nach einem der vorhergehenden Ansprüche, wobei der Source/Drain-Bereich (51, 52) durch selektive Epitaxie gebildet wird, nur ausgehend von der Facette (211a-211i, 221a-221i) des Kanals (20).

## Claims

1. A method for forming at least one source/drain region (51, 52) of at least one transistor, comprising the following steps:
- providing a bulk substrate (1) carrying a transistor pattern (2),
said bulk substrate (1) comprising:
∘ a base portion (10) made of a semiconductor material having an upper face (100) extending in a basal plane and elongated along a longitudinal axis (x), and
∘ first and second insulation portions (11, 12) located on either side of said base portion (10),
said transistor pattern (2) comprising:
∘ a channel (20, 21) surmounting the base portion (10) and extending in particular along the longitudinal axis (x),
∘ a transistor gate pattern (3) surrounding a central portion (200) of the channel (20, 21), the gate pattern (3) having a side,
∘ a spacer (4) covering the side of the gate pattern (3) and transversely surrounding a lateral portion (210, 220) of the channel (20, 21),
the lateral portion (210, 220) of the channel (20) and the spacer (4) respectively having a facet (211a-211i, 221a-221i) and a side (411, 421) extending transversely to the longitudinal axis (x),
- forming an additional insulation portion (110, 120) in the base portion (10), by oxidation of the semiconductor material from the upper face (100) of the base portion (10),
- forming by selective epitaxy a source/drain region (51, 52) from said facet (211a-211i, 221a-221i) of the channel (20),
the method being **characterised in that** it further comprises the following steps:
- before forming the additional insulation portion (110, 120), forming a protective layer (40) on the facet (211a-211i, 221a-221i) of the channel (20), said protective layer (40) being configured to prevent oxidation of the lateral portion (210, 220) of the channel (20) when forming the additional insulation portion (110, 120) by oxidation,
- after forming the additional insulation portion (110, 120) and before forming the source/drain region (51, 52), removing the protective layer (40) so as to expose the facet (211a-211i, 221a-221i).

2. The method according to the preceding claim wherein the additional insulation portion (110, 120) extends under the protective layer (40).

3. The method according to any one of the preceding claims further comprising, after forming the additional insulation portion (110, 120) and before removing the protective layer (40), thinning the additional insulation portion (110, 120) in a direction normal to the basal plane.

4. The method according to any one of claims 1 or 2 further comprising, before forming the additional insulation portion (110, 120) and after forming the protective layer (40), selectively etching the base portion (10) with respect to the first and second insulation portions (11, 12) and the protective layer (40), said selective etching being configured to etch the semiconductor material of the base portion (10) from the upper face (100) over a depth comprised between 2 nm and 30 nm.

5. The method according to any one of the preceding claims, wherein the additional insulation portion (110, 120) extends beyond the protective layer (40), under the lateral portion (210, 220) of the channel.

6. The method according to any one of the preceding claims, wherein the additional insulation portion (110, 120) extends under the entire channel (20).

7. The method according to any one of the preceding claims, wherein the formation of the additional insulation portion (110, 120) is done by thermal oxidation, said thermal oxidation being configured to propagate mainly from the upper face (100), mainly along the longitudinal axis (x).

8. The method according to any one of the preceding claims, wherein at least part of the source/drain region (51, 52) formed by lateral epitaxy is not in contact with the additional insulation portion (110, 120).

9. The method according to any one of claims 1 to 7, wherein the lateral epitaxy is configured so that the source/drain region (51, 52) is in contact with the additional insulation portion (110, 120).

10. The method according to any one of the preceding claims further comprising forming a metallic contact (61,62) surrounding the source/drain region (51,52).

11. The method according to any one of the preceding claims, wherein the protective layer (40) bears on the upper face (100) of the base portion (10).

12. The method according to any one of the preceding claims, wherein the facet (211a-211i, 221a-221i) and the side (411, 421) extend substantially in the same plane, transverse to the longitudinal axis (x).

13. The method according to any one of the preceding claims, wherein the channel (20) is in contact with the base portion (10) and has a shape projecting from the basal plane, for example a fin shape, so that the at least one transistor is a Fingeometry field-effect transistor, called FinFET.

14. The method according to any one of the preceding claims wherein a plurality of channels (21) is formed, each channel having:
- a central portion surrounded at least partially by the transistor gate pattern, and
- a lateral portion surrounded at least partially by the spacer (4) and having a facet (211a-211i, 221a-221i) extending transversely to the longitudinal axis (x),
- a source/drain region (51, 52) being produced by epitaxy from the facets (211a-211i, 221a-221i) of the plurality of channels (21).

15. The method according to any one of the preceding claims, wherein the source/drain region (51, 52) is formed by selective epitaxy only from said facet (211a-211i, 221a-221i) of the channel (20).
